# EUROPEAN PATENT SPECIFICATION

(11) **EP 2 713 399 B1**
(45) Date of publication and mention of the grant of the patent: **13.07.2022**
(21) Application number: 13168105.8
(22) Date of filing: 16.05.2013
(51) Int. Cl.: H01L 27/32, G03F 7/00, H01L 51/56, B41M 5/46

(54) **Method for manufacturing an organic light emitting display device**
Herstellungsverfahren für eine Organische lichtemittierende Anzeigevorrichtung
Procédé de fabrication d'un dispositif à affichage électroluminescent organique

(30) Priority: 27.09.2012 KR 20120108349; 10.04.2013 KR 20130039167
(43) Date of publication of application: 02.04.2014
(73) Proprietor: LG Display Co., Ltd., SEOUL, 07336 (KR)
(72) Inventor: Son, Young Tae, Goyang-si, Gyeonggi-do 411-821 (KR); Kim, Jin Wuk, Goyang-si, Gyeonggi-do 411-736 (KR); Kim, Wy-Yong, Seoul 152-785 (KR)
(74) Representative: Ter Meer Steinmeister & Partner

(56) References cited:
- JP-A- 2005 003 979
- US-A1- 2007 252 525
- US-A1- 2008 199 984
- US-A1- 2009 184 636
- ETIENNE MENARD ET AL: "Micro- and Nanopatterning Techniques for Organic Electronic and Optoelectronic Systems", CHEMICAL REVIEWS, AMERICAN CHEMICAL SOCIETY, WASHINGTON, DC, US, vol. 107, January 2007 (2007-01), pages 1117-1160, XP007911140, DOI: 10.1021/CR050139Y [retrieved on 2007-11-04]

## Description

### BACKGROUND

### Field of the Invention

The present invention relates to a method for manufacturing of an organic light emitting display device, and more particularly, to a method for manufacturing of an organic light emitting display device applicable to high resolution and a large area.

### Discussion of the Related Art

As a type of new flat panel display device, organic light emitting display devices including organic light emitting diodes (OLEDs) are self-emitting display devices, and have a better viewing angle and contrast ratio than liquid crystal display (LCD) devices. Also, since the organic light emitting display devices do not need a separate backlight, it is possible to lighten and thin the organic light emitting display devices, and the organic light emitting display devices have excellent power consumption compared to LCD devices and the other flat panel display devices. Furthermore, the organic light emitting display devices are driven with a low direct current (DC) voltage, have a fast response time, and are low in manufacturing cost.

In the organic light emitting display devices, a fine metal mask (FMM) process, an inkjet process, a lift-off process, or the like is used for patterning an emission layer between two electrodes disposed on a substrate.

However, due to limitations of mask manufacturing technology, it is difficult to apply the FMM process to a large size and high resolution. That is, when the organic light emitting display device is applied to a large area, a mask sags due to the weight thereof, and thus, it is difficult to form a desired pattern. Also, the spread of organic materials increases due to a separated distance between the mask and a deposition portion, and therefore, it is difficult to realize high resolution. Furthermore, since the inkjet process needs to use a liquid material, the performance of an OLED exposed by a process is degraded. Especially, in the existing methods including an etching process, a disconnection occurs by direct contact between metal and etching solutions, or it is not easy to control an etching depth, causing the decrease in device characteristic.

Also, the lift-off process includes only an exposure operation and a development operation except an etching operation among operations included in a photo masking process, thereby enabling formation of a fine pattern. However, the defect of an emission layer is caused by organic materials used in a removing operation and foreign matters that are formed by strong adhesive strength in an operation of removing a photoresist pattern, and therefore, the lift-off process still degrades the efficient characteristic of a display device.

US 2009/0184636 A1 relates to an LED device that includes electrodes patterned over a substrate; the pattern forming several first electrodes separated by inter-electrode spacers. One or more light-emitting layers are formed over the first electrodes. A patterned conductive layer is formed over the one or more light-emitting layers and over the first electrodes in regions external to the inter-electrode spacers. A continuous unpatterned conductive layer is formed over both the patterned conductive layer and the inter-electrode spacers. Finally, a combination of the patterned and continuous unpatterned conductive layers form a single, bi-layered, electrically continuous second electrode.

US 2008/199984 A1 relates to light-emitting devices. Raised areas may be formed over a substrate. The raised areas maybe located around a light-emitting area and may be employed to insulate electrodes formed over the substrate. A masking film may be located over the substrate and in contact with the raised areas. Laser ablation may be performed to remove the material from the mask hole or to detach the mask hole material by ablating masking film material in the perimeter of the mask hole. The remaining masking film material is then detached.

### SUMMARY

Accordingly, the present invention is directed to a method of manufacturing an organic light emitting display device that substantially obviates one or more problems due to limitations and disadvantages of the related art.

An aspect of the present invention is directed to a method of manufacturing an organic light emitting display device that is applicable to high resolution and a large area, and can improve the emission efficiency of a display device.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings. The objects are solved by the features of independent claim 1.

The general idea of the invention relates to a method of manufacturing an organic light emitting display device in which a photoresist pattern formed on a bank layer performs a function of a mask, and thus, the damage of the organic emission layer is minimized and the formation of a pattern is facilitated. In particular, the contact of an organic emission layer can be prevented and damage thereof by foreign matters can be minimized.

According to one example, there is provided a method of manufacturing an organic light emitting display device which includes forming on a substrate a bank layer, or bank layer structures. Preferably, the bank layer is formed on an array substrate of an organic light emitting display device including at least one of driving elements, a passivation layer and an electrode. In one example, the bank layer is formed on a passivation layer. However, most preferably, the bank layer is at least partially formed on an electrode. Here, the bank layer may be patterned as a plurality of spacers or pillars at boundary portions between adjacent sub-pixels. Preferably, the bank layer is used as a spacer or dam layer in the completed device. On the bank layer, a photoresist film is e formed. Preferably, the photoresist film is laminated on the bank layer such that it rests on the bank layer. Hence, the photoresist film may only be in contact with the bank layer. In other words, the photoresist film may bridge between the adjacent bank layer structures. Preferably, the photoresist film is stable enough to maintain a distance defined by the bank layer to the substrate, i. e. without sagging between pillar-like structures of the bank layer. After forming the photoresist film on the bank layer, the photoresist film is patterned in order to form a photoresist film pattern.

Preferably, IR light, e.g. from a laser, is used for forming the photoresist pattern, which is less harmful than UV light. However, also UV light may be used. The pattern is formed on all areas except for areas corresponding to sub-pixels that are to be filled with organic emission layer. Thus, the photoresist pattern includes openings in the areas of the substrate, in which an organic emission layer is to be formed in the next step. This is achieved by irradiating light on the areas in which the photoresist pattern is to be formed or by irradiating light on all areas except for the areas in which the photoresist pattern is to be formed, depending on the type of photoresist film. Then, an organic emission layer is formed in the open areas of the photoresist pattern and subsequently, the photoresist pattern is removed. Preferably, the organic emission layer is formed or deposited to a height less than the height of the bank layer. By these means, when repeating the steps of laminating a photoresist and forming a photoresist pattern for depositing an organic emission layer in other areas of the substrate, the already deposited emission layer may be prevented to be influenced by this process. In particular, the photoresist film preferably does not contact the already deposited organic emission layer.

Preferably, the steps of laminating a photoresist film on the bank layer, forming a photoresist pattern and depositing an organic emission layer are repeated wherein a different organic emission layer may be formed on different areas of the substrate. For instance, these steps may be repeated in order to deposit organic emission layers for red, green and blue sub-pixels, respectively, on the substrate.

The bank layer may include an insulating material.

The substrate may include driving elements, e. g. driving thin film transistors, switching thin film transistors or compensation circuits. Furthermore, a passivation layer may be formed on the substrate. In this case, an electrode may be formed on the passivation layer in each of the plurality of sub-pixels. Also, the bank layer may be formed on the passivation layer. Preferably, the bank layer is at least partially overlapping with an electrode or formed on the electrode.

According to a preferred embodiment, the photoresist film includes a photoresist composition material, such as a shield layer or organic shield layer. Preferably, the photoresist film includes further a light expansion layer that may selectively absorb light of a predetermined wavelength, converting the light into heat and then expanding with the generated heat energy. Additionally, the photoresist film may include a supporting film for supporting the photoresist composition material. The photoresist composition material may include a resin hardening at a predetermined wavelength and an additive, such as a photo initiator, a photoacid generator and/or binder. In one embodiment, a photoresist film includes a light expansion layer configured to absorb infrared light and/or a photoresist composition material including an ultraviolet hardening resin.

According to the invention, the substrate is inverted such that the photoresist film is disposed in a lower portion, and in the inverted state, an irradiated or a non-irradiated portion of the photoresist film is removed for forming the photoresist pattern. That is, the substrate is turned such that the photoresist film faces downwards, i.e. in direction of the ground. By these means, foreign matter generated by removing a part of the photoresist film will fall downwards due to gravity and thus not on the substrate. In an example not forming part of the claimed invention, this effect may also be achieved by applying suction in a direction pointing away from the substrate, in order to suck off foreign matter generated during formation of the photoresist pattern.

According to the invention, when removing the photoresist pattern, the substrate is inverted such that the deposited organic emission layer is disposed in a lower portion, and in the inverted state, the photoresist pattern is removed.

According to one particular embodiment, a method of manufacturing an organic light emitting display device which may include at least some of the steps of: forming a driving thin film transistor on a substrate; forming a passivation layer on the driving thin film transistor; forming an anode electrode in each of a plurality of sub-pixels, on the passivation layer; forming a bank layer at a boundary portion between adjacent sub-pixels, on the passivation layer and/or at least partially on an electrode; laminating a photoresist film on the bank layer; irradiating light in an area of the photoresist film; forming a first photoresist pattern by removing the irradiated or non-irradiated photoresist film on a first sub-pixel area; depositing a first organic emission layer in the first sub-pixel area exposed by the first photoresist pattern; and removing the first photoresist pattern. For forming the first phtoresist pattern, the substrate is inverted such that the photoresist film on the bank layer is facing in a downward direction. Moreover, before removing the photoresist pattern, the substrate is inverted such that the first deposited organic emission layer is disposed in a lower portion. By these means, it can be prevented that foreign matter caused by the formation of the photoresist pattern or by the removal of the photoresist pattern is getting into contact with the emission layer. Preferably, a second photoresist pattern is formed, as described for the first photoresist pattern, having openings on a second sub-pixel area, a second organic emission layer is formed in the second sub-pixel area and the second photoresist pattern is removed.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiments of the invention and together with the description serve to explain the principle of the invention. In the drawings:
FIG. 1 is a sectional view illustrating a photoresist film according to a non-claimed example useful for the understanding of the present invention;
FIGS. 2 to 8 are sectional views for describing a method of manufacturing an organic light emitting display device using the photoresist film according to a non-claimed example useful for the understanding of the present invention; and
FIGS. 9 to 18 are sectional views for describing a method of manufacturing an organic light emitting display device using the photoresist film according to embodiments of the present invention and examples not forming part of the claimed invention. .

### DETAILED DESCRIPTION OF THE INVENTION

Hereinafter, embodiments of the present invention will be described in detail with reference to the accompanying drawings. Like reference numerals refer to like elements throughout. In the following description, when the detailed description of the relevant known function or configuration is determined to unnecessarily obscure the important point of the present invention, the detailed description is not provided.

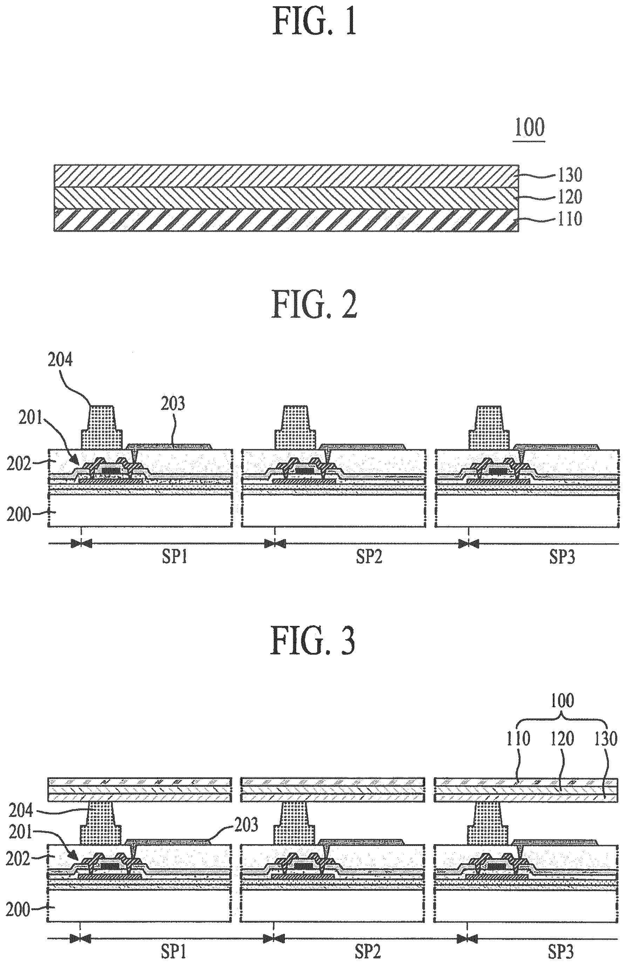

FIG. 1 is a sectional view illustrating a photoresist film according to non-claimed example useful for the understanding of the present invention.

Referring to FIG. 1, a photoresist film 100 includes a supporting film 110, a light expansion layer 120, and a photoresist composition material 130, such as a shielding material, preferably an organic shielding material 130.

In the photoresist film 100, the light expansion layer 120 may be formed on the supporting film 110, and the organic shielding material 130 may be formed on the light expansion layer 120.

The supporting film 110 protects and supports the light expansion layer 120 and the organic shielding material 130.

The supporting film 110 may include at least one of glass, a transparent film, or a polymer film that has excellent light transmittance. As an example of a suitable type of polymer film, the supporting film 110 may be at least one of a polyester (PS) film, a polyethylene terephthalate (PET) film or a polyethylene naphthalate (PEN) film. However, the supporting film 10 may also be formed of at least one of various materials.

Moreover, the light expansion layer 120 selectively absorbs only infrared (IR) light, converts the IR light into heat, and then is expanded with generated heat energy.

The light expansion layer 120 may include a material that has excellent properties for absorbing IR light and has a high ability for converting light energy to heat energy. For example, the light expansion layer 120 may include an organic compound such as carbon black, graphite pigment, and/or IR dye, metal such as Al, Sn, Ti or the like, oxide thereof, or a compound thereof.

The organic shielding material 130 is photoresist (PR) that may include an ultraviolet (UV) hardening resin, so that it is not affected by IR light.

Optionally, the organic shielding material 130 additionally includes an additive and thus has good elasticity.

The organic shielding material 130 may include a UV hardening resin, and may be an organic compound having an acrylic group and/or a vinyl group. For example, a UV hardening resin may include poly methyl methacrylate (PMMA), butyl methacrylate (BMA), urethane acrylate, and/or poly vinyl alcohol.

In addition to the above-described configuration, the organic shielding material 130 may include at least one of various additives. For example, the organic shielding material 130 may include a photoinitiator and/or a photoacid generator as an additive, and/or may include an additive such as a binder and/or a monomer including the same.

A photoinitiator hardens a binder in irradiating light, thereby increasing a hardening degree of the photoresist film 100. For example, the photoinitiator may include at least one of acetophenone, benzophenone, oxime or the like. The kind or content of the photoinitiator may be adjusted or determined depending on a desired pattern shape or a wavelength range of an exposure process.

A photoacid generator generates acid in irradiating light. For example, the photoacid generator may include triarylsulfonium salts, diaryliodonium salts, sulfonates, or a compound thereof.

A binder acts as a cross linking agent in irradiating light. For example, the binder may include novolak, polyseter acrylate, epoxy acrylate, and/or urethane acrylate.

However, the present example is not limited thereto, and the photoresist film 100 may be formed of at least one of various materials.

The organic shielding material 130 is sprayed or coated on the light expansion layer 120, e.g. using one of an air knife, a roll coater, a spray, a dipping coater, a gravure coater, a spin coater, a bar coater, a doctor blade, and a slit coater, thereby forming the photoresist film 100. Alternatively, it may be designed that the organic shielding material 130 is formed in a film shape and then adhered to the light expansion layer 120. The organic shielding material 130 may have a thickness of 5 *µ*m to 25 *µ*m.

Therefore, the photoresist film 100 may be disposed on a bank layer 204, for forming a desired pattern. In this case, the photoresist film 100 is laminated such that a top of the bank layer 204 contacts the organic shielding material 130.

Next, a method that forms a desired pattern by laminating the photoresist film 100 and manufactures an organic light emitting display device will now be described in detail.

FIGS. 2 to 8 are sectional views for describing a method of manufacturing an organic light emitting display device using the photoresist film according to a non-claimed example useful for the understanding of present invention.

As illustrated in FIG. 2, a driving thin film transistor 201, a passivation layer 202, a first electrode 203, and the bank layer 204 are formed on a substrate 200.

An organic light emitting diode (OLED) includes the first electrode 203, a second electrode (not shown), and a plurality of organic emission layers 205, 206, and 207 formed therebetween. Therefore, a drain of the driving TFT 201 is electrically connected to the first electrode 203.

In this case, the first electrode 203 is an anode electrode, and is separately formed on the passivation layer 202 to contact the drain, in each of a plurality of sub-pixels. Here, the first electrode 203 may act as one of a plurality of electrodes included in an OLED, and may be formed of at least one of various conductive materials. Also, the first electrode 203 may be formed as a transparent electrode or a reflective electrode. When the first electrode 203 is used as the transparent electrode, the first electrode 203 may be formed of at least one of ITO, IZO, ZnO, or In₂O₃. When the first electrode 203 is used as the reflective electrode, a reflective film may be formed of at least one of Ag, Mg, Al, Pt, Pd, Au, Ni, Nd, Ir, and Cr and a compound thereof, and then, the first electrode 203 may be formed of at least one of ITO, IZO, ZnO, or In₂O₃ on the reflective film.

Although not shown, the second electrode (not shown) is formed over the substrate 200, on the organic emission layers 205, 206 and 207. Here, the second electrode may be formed as a transparent electrode or a reflective electrode like the first electrode 203. When the second electrode is used as the transparent electrode, the OLED may include: a layer that is formed of at least one of Li, Ca, LiF/Ca, LiF/Al, Al, Mg, or a compound thereof and an assistant electrode or a bus electrode line that is formed of a transparent-electrode material, such as ITO, IZO, ZnO, and/or In₂O₃, on the layer. Also, when the second electrode is used as the reflective electrode, the second electrode may be formed by depositing at least one of Li, Ca, LiF/Ca, LiF/Al, Al, Mg, or a compound thereof over the substrate 200.

The organic emission layers 205, 206, and 207 are patterned and formed in correspondence with respective sub-pixel areas SP1 to SP3. Here, the organic emission layers 205, 206, and 207 may be formed as a single layer of a light emitting material, or formed as a multilayer including at least one of a hole injection layer, a hole transport layer, an emission layer (emitting material layer), an electron transport layer, and an electron injection layer for enhancing emission efficiency.

Here, the hole injection layer enables a hole to be smoothly injected from the first electrode 203 into the emission layer, and may be formed of at least one of cupper phthalocyanine (CuPc), poly(3,4)-ethylenedioxythiophene (PEDOT), polyaniline (PANI), and N,N-dinaphthyl-N,N'-diphenyl benzidine (NPD).

The hole transport layer easily transports a hole to the emission layer, and moreover prevents an electron, generated from the cathode, from being moved to the emission area, thus increasing emission efficiency. That is, the hole transport layer enables the smooth transport of a hole, and may be formed of at least one of N,N-dinaphthyl-N,N'-diphenyl benzidine (NPD), N,N'-bis-(3-methylphenyl)-N,N'-bis-(phenyl)-benzidine (TPD), s-TAD, and 4,4',4"-Tris(N-3-methylphenyl-N-phenyl-amino)-triphenylamine (MTDATA).

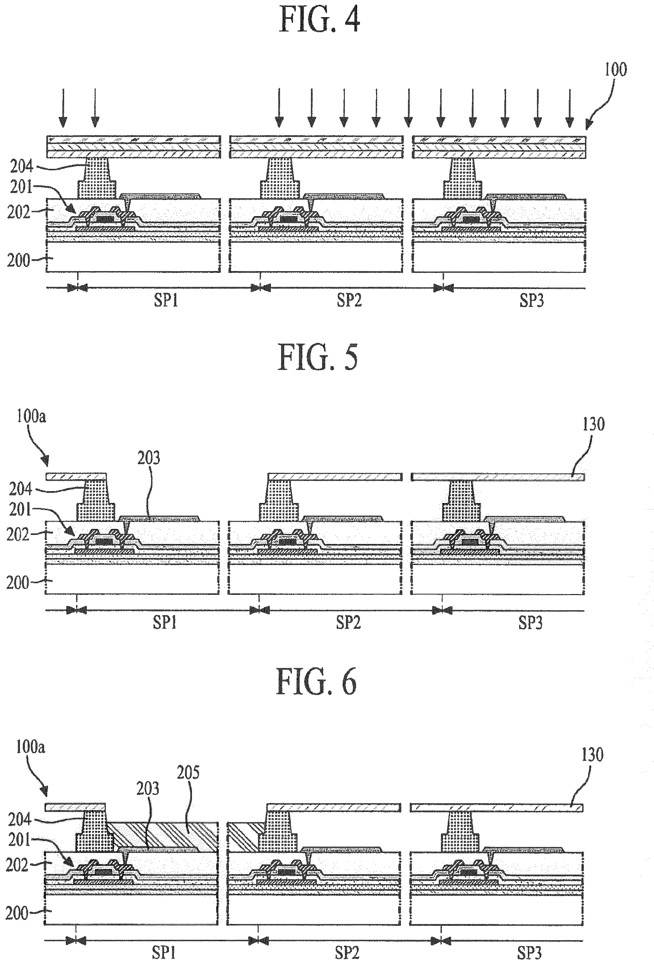

The emission layer may include a host and a dopant. Also, the emission layer may be formed of a light emitting material for emitting red light, green light, blue light, or white light, or formed of a phosphor material or a fluorescent material. In a description on such light emitting materials, various materials will be described with reference to FIG. 6.

The electron transport layer enables the smooth transport of an electron, and may be formed of at least one of tris(8-hydroxyquinolino) aluminum (Alq3), PBD, TAZ, spiro-PBD, BAlq, and SAlq.

The electron injection layer enables the smooth injection of an electron, and may be formed of at least one of tris(8-hydroxyquinolino) aluminum (Alq3), PBD, TAZ, LiF, spiro-PBD, BAlq, and SAlq.

The bank layer 204 may be patterned in order for a partial region of the first electrode 203 to be exposed, and at least partially formed in each of the sub-pixel areas SP1 to SP3 on the first electrode 203. That is, by forming the bank layer 204, an opening in a photoresist pattern may be formed on the first electrode 203, and the organic emission layers 205, 206, and 207 may be formed inside the opening.

Here, the bank layer 204 may be formed of an insulating material such as silicon oxide (SiOx) or silicon nitride (SiNx). In addition, the bank layer 204 may be formed of at least one of various insulating organic materials.

Therefore, in the organic light emitting display device, when a certain voltage is applied to the first electrode 203 and the second electrode (not shown) to according to a selected color signal, a hole and an electron are transported to the organic emission layers 205, 206, and 207 to generate an exciton, and, when the exciton is shifted from an excited state to a base state, visible light is emitted. At this point, the emitted light is transferred to the outside through the second transparent electrode (not shown), thereby realizing an image.

Subsequently, an encapsulation operation may be performed for protecting an OLED of each sub-pixel from the outside. In the present invention, a general thin film encapsulation process may be used. The thin film encapsulation process is known technology, and thus, its detailed description is not provided in the specification.

As described above, the method of manufacturing the organic light emitting display device (for example, OLED) has been described above as an example. However, in addition to a switching thin film transistor (not shown) and a driving thin film transistor that are formed in a unit pixel, a compensation circuit for compensating for a threshold voltage of the driving thin film transistor may be provided. Namely, a plurality of driving elements may be additionally formed. The driving elements may be freely disposed in a pixel.

Subsequently, as illustrated in FIG. 3, the photoresist film 100 is laminated on the bank layer 204.

The photoresist film 100 including the supporting film 110, the light expansion layer 120, and the organic shielding material 130 is disposed to face an upper region of the bank layer 204 formed on the passivation layer 202, and then laminated uniformly. In this case, lamination is uniformly performed such that the photoresist film 100 does not sag in an opening formed due to the bank layer 204.

Although not shown, an assistant bank layer (not shown) may be further formed between adjacent bank layers 204 in order for the photoresist film 100 to be uniformly laminated.

Subsequently, as illustrated in FIGS. 4 and 5, a photoresist pattern 100a is formed by irradiating IR light on the photoresist film 100.

In irradiating a laser on a top of the photoresist film 100, an IR laser is irradiated on only an area except for an area in which an organic emission layer is to be provided, e.g. except the first sub-pixel area SP1 in Fig. 4. Therefore, the photoresist pattern 100a has an opening for depositing an organic emission layer with a red light emitting material.

In this case, an IR laser having a wavelength of 1000 nm or more is irradiated on a scan region in the top of the photoresist film 100 by using a scan process or a separate mask. IR irradiation may be designed to have a constant energy density, wavelength, and irradiating time, but, for example, IR irradiation may be designed to have an energy density and a irradiating time at a wavelength band of 1000 nm or more. Of course, also other wavelengths can be used for irradiation, depending on the composition of the photoresist film 100.

Therefore, in the photoresist film 100, volume expansion due to heat is performed in only a region on which a laser has been irradiated, and layer detachment is performed. That is, volume expansion is performed in only the light expansion layer 120 on which a laser has been irradiated, and the light expansion layer 120 is detached from the organic shielding material 130. Here, layer detachment between the light expansion layer 120 and the organic shielding material 130 is not performed in a region (i.e., the first sub-pixel area SP1) on which a laser is not irradiated. Therefore, layer detachment is performed in only a region (i.e., a region on which a laser has been irradiated) except the first sub-pixel SP1, and, by removing the light expansion layer 120 in which layer detachment has occurred, the photoresist pattern 100a is left in only a region on which a laser has been irradiated.

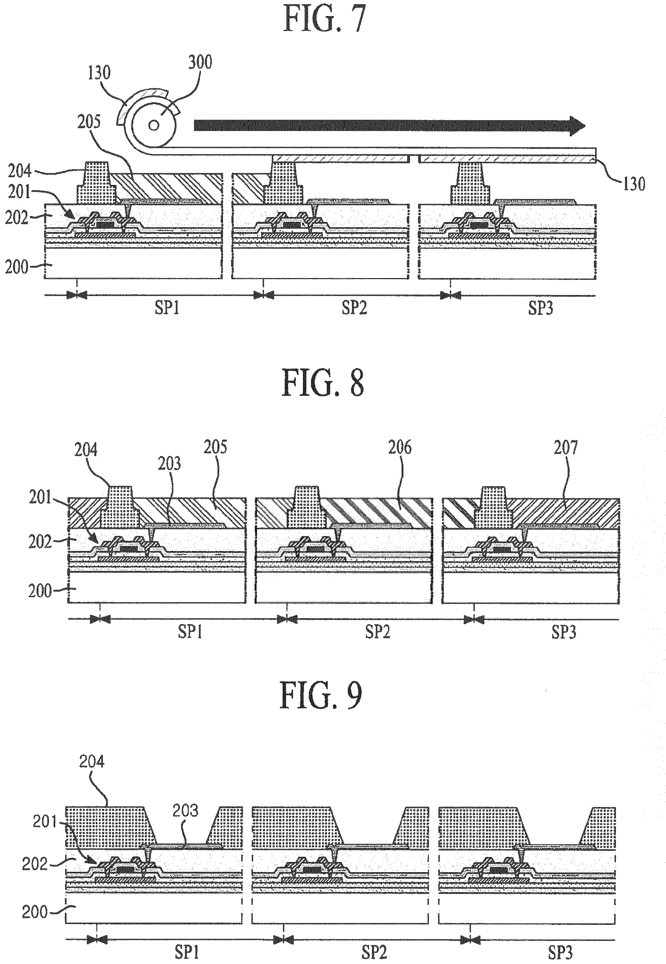

As a result, the photoresist pattern 100a in which an opening is formed in a first sub-pixel area (SP1 of FIG. 8) may be designed so as to enable the deposition of a red, blue, or green organic emission layer (205 of FIG. 8).

Although not shown, a photoresist pattern in which an opening is formed in a second sub-pixel area (SP2 of FIG. 8) or in a third sub-pixel area (SP3 of FIG. 8) may be designed so as to enable the deposition of a red, blue, or green organic emission layer (206 or 207 of FIG. 8).

In this case, a photoresist pattern may be formed by irradiating an IR laser and separately adjusting a temperature, and an additional process such as temperature adjustment may be variously applied according to characteristic of a photoresist film.

Subsequently, as illustrated in FIG. 6, the organic emission layer 205 is deposited on the first electrode 203 exposed by the photoresist pattern 100a.

The organic emission layer 205 is deposited with a red light emitting material, on a top of the first electrode 203 exposed by the photoresist pattern 100a, namely, in the first sub-pixel area SP1.

Although not shown, in addition to the red light emitting material, the organic emission layer (206 of FIG. 8) may be deposited with a green light emitting material in the second sub-pixel area SP2, and the organic emission layer (207 of FIG. 8) may be deposited with a blue light emitting material in the third sub-pixel area SP3.

Here, a red light emitting material may include a host material including carbazole biphenyl (CBP) and/or 1,3-bis(carbazol-9-yl) (mCP), and include a phosphor material including a dopant including one or more selected from the group consisting of PIQIr(acac)(bis(1-phenylisoquinoline)acetylacetonate iridium), PQIr(acac)(bis(1-phenylquinoline)acetylacetonate iridium), PQIr(tris(1-phenylquinoline)iridium), and PtOEP(octaethylporphyrin platinum). On the other hand, the red light emitting material may include a phosphor material including PBD:Eu(DBM)3(Phen) and/or Perylene.

A green light emitting material may include a host material including CBP and/or mCP, and may include a phosphor material including a dopant including Ir(ppy)3(fac tris(2-phenylpyridine)iridium). On the other hand, the red light emitting material may include a phosphor material including Alq3(tris(8-hydroxyquinolino)aluminum).

A blue light emitting material may include a host material including CBP and/or mCP, and may include a phosphor material including a dopant including (4,6-F2ppy)2Irpic and/or L2BD111. On the other hand, the red light emitting material may include a phosphor material including a dopant including one or more selected from the group consisting of spiro-DPVBi, spiro-6P, DSB, DSA, PFO-based polymer, and PPV-based polymer.

For example, the organic emission layer (205 of FIG. 8) may be formed of a low molecular material such as Alq3 (host)/DCJTB (fluorescent dopant), Alq3 (host)/DCM (fluorescent dopant), and/or CBP (host)/PtOEP (phosphor organic metal complex) that is a red light emitting material, and a polymer material such as PFO-based polymer and/or PPV-based polymer. The organic emission layer (206 of FIG. 8) may be formed of a low molecular material such as Alq3, Alq3 (host)/C545t (dopant), and/or CBP (host)/IrPPY (phosphor organic material complex) that is a green light emitting material, and a polymer material such as PFO-based polymer and/or PPV-based polymer. The organic emission layer (207 of FIG. 8) may be formed of a low molecular material such as DPVBi, spiro-DPVBi, spiro-6P, DSB, and/or DSA that is a blue light emitting material, and a polymer material such as PFO-based polymer and/or PPV-based polymer.

Finally, as illustrated in FIGS. 7 and 8, by removing the photoresist pattern 100a, the OLED in which the organic emission layers 205, 206, and 207 are formed on the first electrode 203 is manufactured.

In an example, a separation roller 300 is disposed on the photoresist pattern 100a formed on the bank layer 204, and, by rotating the separation roller 300, the photoresist pattern 100a may be easily removed from the bank layer 204.

In this case, the separation roller 300 may include a detach film having adhesive strength similar to that of a generally used tape. As another example, the photoresist pattern 100a may be easily removed from the bank layer 204 with separation instruments having various sizes or shapes.

By repeatedly performing the manufacturing method of FIGS. 4 to 7, the organic emission layers 205, 206, and 207 are formed in the respective unit sub-pixels, and, by continuously depositing materials of the hole transport layer as well as the organic emission layer in all corresponding sub-pixels, the OLED may be manufactured.

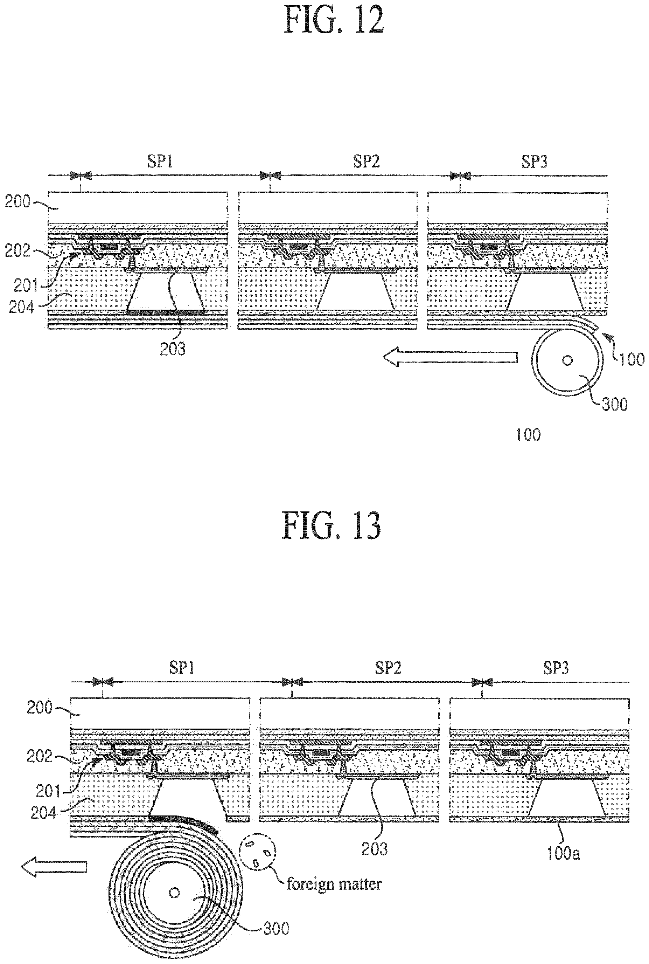

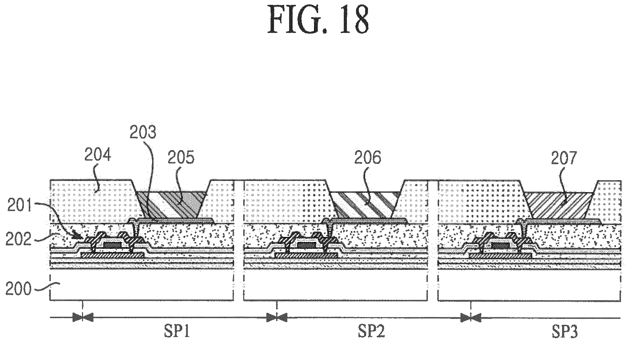

FIGS. 9 to 18 are sectional views for describing a method of manufacturing an organic light emitting display device using the photoresist film according to embodiments of the present invention and non-claimed examples . Here, a description on the configuration that is the same as the configuration of the above-described method of manufacturing an organic light emitting display device using the photoresist film according to the example is not provided or will be briefly described below.

As illustrated in FIG. 9, a driving thin film transistor 201, a passivation layer 202, a first electrode 203, and the bank layer 204 are formed on a substrate 200.

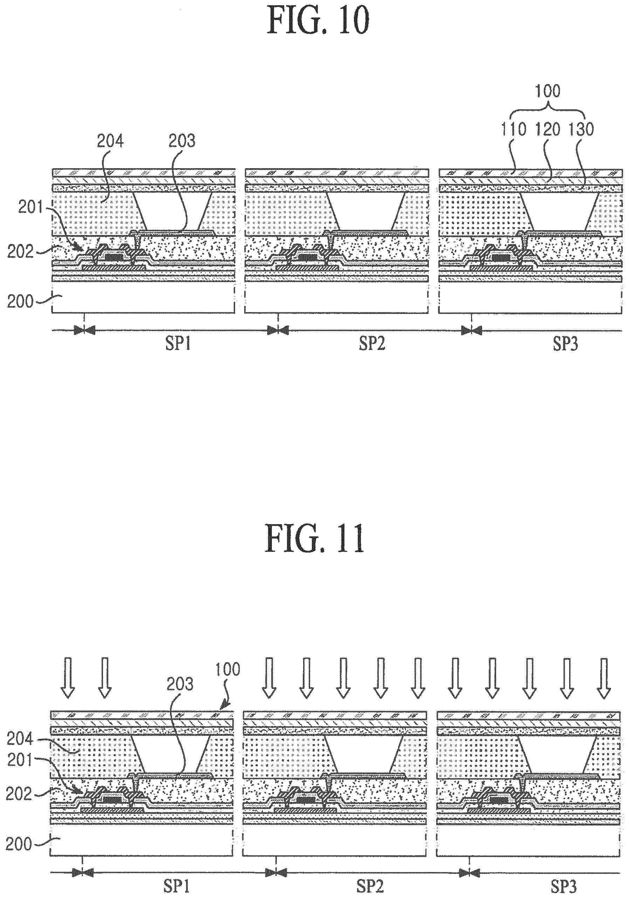

Subsequently, as illustrated in FIG. 10, the photoresist film 100 is laminated on the bank layer 204.

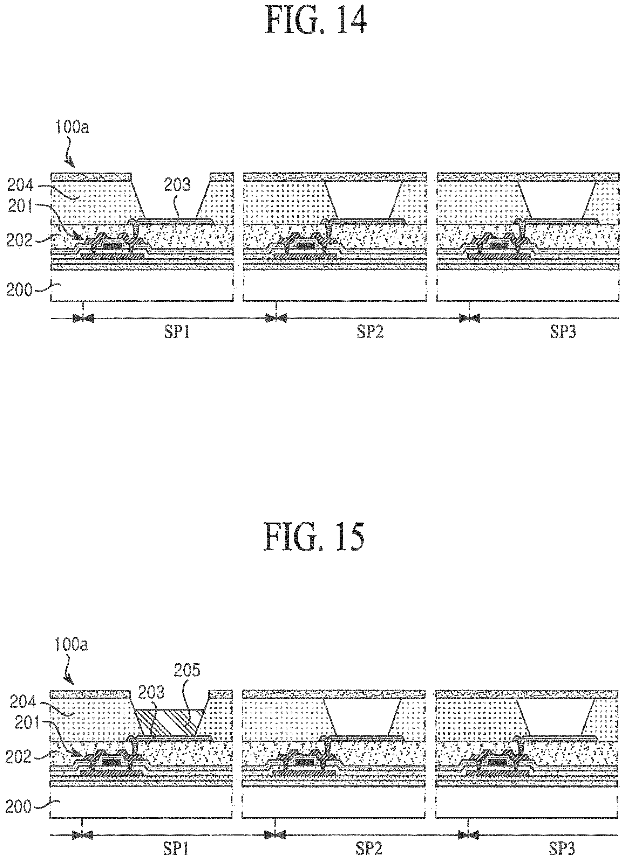

Subsequently, as illustrated in FIGS. 11 and 14, a photoresist pattern 100a is formed by irradiating IR light on the photoresist film 100.

According to the invention, the substrate 200 is inverted such that the photoresist film 100 on which IR light is irradiated is disposed in a lower portion, and in the inverted state, the first photoresist pattern 100a is formed by removing a light expansion layer in which layer detachment is created. Here, if the light expansion layer is removed in the inverted state, the falling foreign matter can be removed toward the direction of gravity, and thus, the foreign matter can be prevented from coming to an inside of the sub-pixel area. That is, the defect of an emission layer EML can be improved by preventing the foreign matter, and thus, the efficient characteristic of a device can be enhanced. Additionally, some suction in the lower direction may be applied.

Subsequently, as illustrated in FIG. 15, the organic emission layer 205 is deposited on the first electrode 203 exposed by the photoresist pattern 100a.

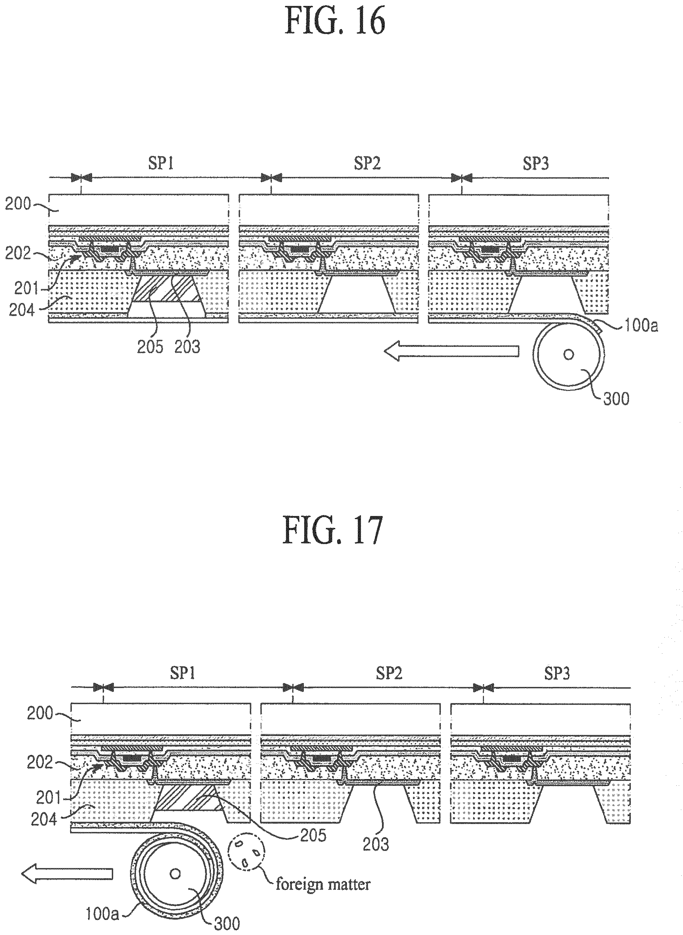

Finally, as illustrated in FIGS. 16 to 18, the substrate 200 is inverted again such that the deposited organic emission layer 205 is disposed in a lower portion, and in the inverted state, a organic light emitting display device, the first electrode 203 of which is formed in the organic emission layers 205, 206 and 207, is manufactured by removing the photoresist pattern 100a.

As described above, in the present invention, the falling foreign matter can be removed toward the direction of gravity by inverting the substrate 200 such that the deposited organic emission layer 205 is disposed in a lower portion, and thus, the foreign matter can be prevented from coming to an inside of the sub-pixel area. That is, the defect of an emission layer EML can be improved by preventing the foreign matter, and thus, the efficient characteristic of a device can be enhanced.

According to the present invention, by repeatedly performing the manufacturing method according to any of the described embodiments, the organic emission layers 205, 206, and 207 are formed in the respective unit sub-pixels, and, by continuously depositing materials of the hole transport layer as well as the organic emission layer in the corresponding sub-pixels for red, green and blue, respectively, the OLED may be manufactured.

Accordingly, in the organic light emitting display device, by introducing the photoresist film according to an embodiment of the present invention, the photoresist pattern formed on the bank layer prevents the contact of the organic emission layer, thus minimizing the damage of the organic emission layer and facilitating the formation of a desired pattern. As a result, the emission characteristic and service life of organic light emitting display device are improved, thus facilitating the manufacturing of the organic light emitting display device and enhancing productivity.

In the method of forming a pattern with the photoresist film according to an embodiment of the present invention, the organic light emitting display device including OLEDs has been exemplified in the specification, but the present invention is not limited thereto. As another example, the present invention may be applied to various display devices such as LCD devices, electrophoresis display (EPD) devices, etc.

According to the present invention, the organic light emitting display device can be applied to high resolution and a large area, and the emission characteristic and service life of organic light emitting display device are improved, thus facilitating the manufacturing of the organic light emitting display device and enhancing productivity.

Moreover, even when the photoresist pattern is formed only one time for each type of sub-pixels, red, green, and blue organic materials and the materials of the HTL and the like may be successively deposited by sub-pixel.

## Claims

1. A method of manufacturing an organic light emitting display device, comprising:
forming a bank layer (204) on a substrate (200) having a plurality of sub-pixels (SP1, SP2, SP3) at a boundary portion between adjacent sub-pixels (SP1, SP2, SP3);
laminating a photoresist film (100) on the bank layer (204);
forming a photoresist pattern (100a) in an area except for predetermined sub-pixels (SP1, SP2, SP3) by irradiating light on the photoresist film (100);
depositing an organic emission layer (205, 206, 207) in the predetermined sub-pixel area exposed by the photoresist pattern (100a); and
removing the photoresist pattern (100a);
wherein the step of removing the photoresist pattern (100a) includes inverting the substrate (200) such that the deposited organic emission layer(205, 206, 207) is disposed in a lower portion, and in the inverted state, removing the photoresist pattern (100a);
**characterized in that** the step of forming the photoresist pattern (100a) includes inverting the substrate (200) such that the photoresist film (100) is disposed in a lower portion, and in the inverted state, removing an irradiated or a non-irradiated portion of the photoresist film (100) for forming the photoresist pattern (100a)

2. The method of claim 1, wherein the steps of laminating a photoresist film (100) on the bank layer (204), forming a photoresist pattern (100a) by irradiating light, depositing an organic emission layer (205, 206, 207) in the predetermined sub-pixel area exposed by the photoresist pattern (100a) and removing the photoresist pattern (100a) are repeated for coating a further organic emission layer (205, 206, 207) in different predetermined sub-pixels (SP1, SP2, SP3).

3. The method of claim 1 or 2, wherein the bank layer (204) includes an insulating material.

4. The method of any one of the preceding claims, including further:
forming a driving thin film transistor (201) on a substrate (200);
forming a passivation layer (202) on the driving thin film transistor (201); and
forming an anode electrode (203) in each of a plurality of sub-pixels (SP1, SP2, SP3), on the passivation layer (202), before forming the bank layer (204) at the boundary portion between adjacent sub-pixels (SP1, SP2, SP3), on the passivation layer (202).

5. The method of any one of the preceding claims 1 to 3, wherein the substrate (200) includes driving elements including at least one of driving thin film transistors (201), switching thin film transistors and a compensation circuit for compensating a threshold voltage of the driving thin film transistor (201).

6. The method of any one of the preceding claims 1 to 3 or 5, wherein the substrate (200) includes a passivation layer (202) and an electrode (203) in each of the plurality of sub-pixels (SP1, SP2, SP3) on the passivation layer (202).

7. The method of any one of the preceding claims, wherein for irradiating light, infrared or ultraviolet light is used.

8. The method of any one of the preceding claims, wherein the photoresist film (100) includes a photoresist composition material (130), a light expansion layer (120) for expanding by selectively absorbing the irradiated light and a supporting film (110) for supporting the light expansion layer (120) and the photoresist composition material (130).

9. The method of any one of the preceding claims, wherein the photoresist film (100) comprises a photoresist composition material (130) that includes an ultraviolet hardening resin and an additive including at least one of a photoinitiator, a photoacid generator and a binder.

10. The method of any one of the preceding claims, wherein the photoresist film (100) comprises a light expansion layer (120) that includes a material absorbing infrared light and has a high ability for converting light energy into heat.

11. The method of any one of the preceding claims, wherein the photoresist film (100) comprises a supporting film (110) including one of glass, a transparent film or a light-transmissive polymer film.

12. The method of any one of the preceding claims, wherein in the step of forming the photoresist pattern (100a):
light is irradiated on the photoresist film (100) in an area except for the predetermined sub-pixel (SP1, SP2, SP3) for removing the photoresist film (100) in the area of the predetermined sub-pixel, or
light is irradiated on the photoresist film (100) in the area of the predetermined sub-pixel (SP1, SP2, SP3) for removing the photoresist film (100) in the area of the predetermined sub-pixel.

## Patentansprüche

1. Verfahren zum Herstellen einer organischen lichtemittierenden Anzeigevorrichtung, das Folgendes umfasst:
Bilden einer Bankschicht (204) auf einem Substrat (200), das mehrere Unterpixel (SP1, SP2, SP3) aufweist, an einem Grenzabschnitt zwischen benachbarten Unterpixeln (SP1, SP2, SP3);
Laminieren eines Photoresistfilms (100) auf die Bankschicht (204);
Bilden eines Photoresistmusters (100a) in einem Bereich mit Ausnahme der vorgegebenen Unterpixel (SP1, SP2, SP3) durch Einstrahlen von Licht auf den Photoresistfilm (100);
Ablagern einer organischen Emissionsschicht (205, 206, 207) in dem vorgegebenen Unterpixelbereich, der durch das Photoresistmuster (100a) freigelegt ist, und
Entfernen des Photoresistmusters (100a);
wobei der Schritt des Entfernens des Photoresistmusters (100a) das Umdrehen des Substrats (200), derart, dass die abgelagerte organische Emissionsschicht (205, 206, 207) in einem unteren Abschnitt angeordnet ist, und das Entfernen des Photoresistmusters (100a) in dem umgedrehten Zustand umfasst;
**dadurch gekennzeichnet, dass** der Schritt des Bildens des Photoresistmusters (100a) das Umdrehen des Substrats (200), derart, dass der Photoresistfilm (100) in einem unteren Abschnitt angeordnet ist, und das Entfernen eines bestrahlten oder eines nicht bestrahlten Abschnitts des Photoresistfilms (100) zum Bilden des Photoresistmusters (100a) in dem umgedrehten Zustand umfasst.

2. Verfahren nach Anspruch 1, wobei die Schritte des Laminierens eines Photoresistfilms (100) auf die Bankschicht (204) das Bilden eines Photoresistmusters (100a) durch Einstrahlen von Licht, das Ablagern der organischen Emissionsschicht (205, 206, 207) in dem vorgegebenen Unterpixelbereich, der durch das Photoresistmuster (100a) freigelegt ist, und das Entfernen des Photoresistmusters (100a) zum Aufbringen einer weiteren organischen Emissionsschicht (205, 206, 207) in den vorgegebenen Unterpixeln (SP1, SP2, SP3) wiederholt werden.

3. Verfahren nach Anspruch 1 oder 2, wobei die Bankschicht (204) ein Isoliermaterial enthält.

4. Verfahren nach einem der vorhergehenden Ansprüche, das ferner Folgendes umfasst:
Bilden eines Ansteuerdünnschichttransistors (201) auf einem Substrat (200);
Bilden einer Passivierungsschicht (202) auf dem Ansteuerdünnschichttransistor (201) und
Bilden einer Anodenelektrode (203) in jedem von mehreren Unterpixeln (SP1, SP2, SP3) auf der Passivierungsschicht (202) vor dem Bilden der Bankschicht (204) an dem Grenzabschnitt zwischen benachbarten Unterpixeln (SP1, SP2, SP3) auf der Passivierungsschicht (202).

5. Verfahren nach einem der vorhergehenden Ansprüche 1 bis 3, wobei das Substrat (200) Ansteuerelemente enthält, die einen Ansteuerdünnschichttransistor (201) und/oder Schaltdünnschichttransistoren und/oder eine Ausgleichsschaltung zum Ausgleichen einer Schwellenwertspannung des Ansteuerdünnschichttransistors (201) umfassen.

6. Verfahren nach einem der vorhergehenden Ansprüche 1 bis 3 oder 5, wobei das Substrat (200) eine Passivierungsschicht (202) und eine Elektrode (203) in jedem der mehreren Unterpixel (SP1, SP2, SP3) auf der Passivierungsschicht (202) enthält.

7. Verfahren nach einem der vorhergehenden Ansprüche, wobei zum Einstrahlen von Licht Infrarot- oder Ultraviolettlicht verwendet wird.

8. Verfahren nach einem der vorhergehenden Ansprüche, wobei der Photoresistfilm (100) ein Photoresistverbundmaterial (130), eine Lichtausdehnungsschicht (120) zum Ausdehnen durch selektives Absorbieren des eingestrahlten Lichts und einen Stützfilm (110) zum Stützen der Lichtausdehnungsschicht (120) und des Photoresistverbundmaterials (130) umfasst.

9. Verfahren nach einem der vorhergehenden Ansprüche, wobei der Photoresistfilm (100) ein Photoresistverbundmaterial (130) umfasst, das ein mit Ultraviolett härtendes Harz und einen Zusatzstoff, der einen Photoinitiator und/oder einen Photosäurenerzeuger und/oder ein Bindemittel enthält, enthält.

10. Verfahren nach einem der vorhergehenden Ansprüche, wobei der Photoresistfilm (100) eine Lichtausdehnungsschicht (120) umfasst, die ein Material enthält, das Infrarotlicht absorbiert und ein hohes Vermögen zum Umsetzen von Lichtenergie in Wärme aufweist.

11. Verfahren nach einem der vorhergehenden Ansprüche, wobei der Photoresistfilm (100) einen Stützfilm (110) umfasst, der Glas und/oder einen transparenten Film und/oder einen lichtdurchlässigen Polymerfilm enthält.

12. Verfahren nach einem der vorhergehenden Ansprüche, wobei in dem Schritt des Bildens des Photoresistmuster (100a):
Licht auf den Photoresistfilm (100) in einem Bereich mit Ausnahme des vorgegebenen Unterpixels (SP1, SP2, SP3) zum Entfernen des Photoresistfilms (100) in dem Bereich des vorgegebenen Unterpixels eingestrahlt wird oder
Licht auf den Photoresistfilm (100) in dem Bereich des vorgegebenen Unterpixels (SP1, SP2, SP3) zum Entfernen des Photoresistfilms (100) in dem Bereich des vorgegebenen Unterpixels eingestrahlt wird.

## Revendications

1. Procédé de fabrication d'un dispositif d'affichage électroluminescent organique, comportant les étapes consistant à :
former une couche de banc (204) sur un substrat (200) ayant une pluralité de sous-pixels (SP1, SP2, SP3) sur une partie de frontière entre des sous-pixels (SP1, SP2, SP3) adjacents ;
stratifier un film de résine photosensible (100) sur la couche de banc (204) ;
former un motif de résine photosensible (100a) dans une zone à l'exception de sous-pixels (SP1, SP2, SP3) prédéterminés en insolant à la lumière le film de résine photosensible (100) ;
déposer une couche d'émission organique (205, 206, 207) dans la zone des sous-pixels prédéterminés exposée par le motif de résine photosensible (100a) ; et
retirer le motif de résine photosensible (100a) ;
dans lequel l'étape de retrait du motif de résine photosensible (100a) inclut l'inversion du substrat (200) de telle sorte que la couche d'émission organique (205, 206, 207) déposée est déposée dans une partie inférieure, et à l'état inversé, retirer le motif de résine photosensible (100a) ;
**caractérisé en ce que** l'étape de formation du motif de résine photosensible (100a) inclut l'inversion du substrat (200) de telle sorte que le film de résine photosensible (100) est disposé dans une partie inférieure, et à l'état inversé, retirer une partie insolée ou non insolée du film de résine photosensible (100) pour former le motif de résine photosensible (100a).

2. Procédé selon la revendication 1, dans lequel les étapes consistant à stratifier un film de résine photosensible (100) sur la couche de banc (204), former un motif de résine photosensible (100a) par insolation à la lumière, déposer une couche d'émission organique (205, 206, 207) dans la zone des sous-pixels prédéterminés exposée par le motif de résine photosensible (100a) et retirer le motif de résine photosensible (100a) sont répétées pour déposer une couche d'émission organique (205, 206, 207) supplémentaire dans différents sous-pixels (SP1, SP2, SP3) prédéterminés.

3. Procédé selon la revendication 1 ou 2, dans lequel la couche de banc (204) inclut un matériau isolant.

4. Procédé selon l'une quelconque des revendications précédentes, incluant en outre les étapes consistant à :
former un transistor d'attaque à couches minces (201) sur un substrat (200) ;
former une couche de passivation (202) sur le transistor d'attaque à couches minces (201) ; et
former une électrode d'anode (203) dans chaque sous-pixel d'une pluralité de sous-pixels (SP1, SP2, SP3), sur la couche de passivation (202), avant de former la couche de banc (204) sur la partie de frontière entre des sous-pixels (SP1, SP2, SP3) adjacents, sur la couche de passivation (202).

5. Procédé selon l'une quelconque des revendications 1 à 3 précédentes, dans lequel le substrat (200) inclut des éléments d'attaque incluant au moins un élément parmi des transistors d'attaque à couches minces (201), des transistors de commutation à couches minces et un circuit de compensation pour compenser une tension de seuil du transistor d'attaque à couches minces (201).

6. Procédé selon l'une quelconque des revendications 1 à 3 ou 5 précédentes, dans lequel le substrat (200) inclut une couche de passation (202) et une électrode (203) dans chaque sous-pixel de la pluralité de sous-pixels (SP1, SP2, SP3) sur la couche de passivation (202).

7. Procédé selon l'une quelconque des revendications précédentes, dans lequel pour l'insolation à la lumière, une lumière infrarouge ou ultraviolette est utilisée.

8. Procédé selon l'une quelconque des revendications précédentes, dans lequel le film de résine photosensible (100) inclut un matériau de composition de résine photosensible (130), une couche d'expansion de lumière (120) pour produire une expansion en absorbant sélectivement la lumière d'insolation et un film de support (110) pour supporter la couche d'expansion de lumière (120) et le matériau de composition de résine photosensible (130).

9. Procédé selon l'une quelconque des revendications précédentes, dans lequel le film de résine photosensible (100) comporte un matériau de composition de résine photosensible (130) qui inclut une résine durcissant aux ultraviolets et un additif incluant au moins un élément parmi un photo-initiateur, un générateur de photoacides et un liant.

10. Procédé selon l'une quelconque des revendications précédentes, dans lequel le film de résine photosensible (100) comporte une couche d'expansion de lumière (120) qui inclut un matériau absorbant la lumière infrarouge et a une haute capacité à convertir de l'énergie lumineuse en chaleur.

11. Procédé selon l'une quelconque des revendications précédentes, dans lequel le film de résine photosensible (100) comporte un film de support (110) incluant un élément parmi du verre, un film transparent ou un film polymère laissant passer la lumière.

12. Procédé selon l'une quelconque des revendications précédentes, dans lequel à l'étape de formation du motif de résine photosensible (100a) :
une insolation à la lumière est réalisée sur le film de résine photosensible (100) dans une zone à l'exception du sous-pixel (SP1, SP2, SP3) prédéterminé pour retirer le film de résine photosensible (100) dans la zone du sous-pixel prédéterminé, ou
une insolation à la lumière est réalisée sur le film de résine photosensible (100) dans une zone du sous-pixel (SP1, SP2, SP3) prédéterminé pour retirer le film de résine photosensible (100) dans la zone du sous-pixel prédéterminé.
